# EUROPEAN PATENT SPECIFICATION

(11) **EP 0 860 862 B1**
(45) Date of publication and mention of the grant of the patent: **26.11.2008**
(21) Application number: 98301259.2
(22) Date of filing: 20.02.1998
(51) Int. Cl.: H01L 21/20, H01L 21/304

(54) **Method of manufacturing a bonding substrate**
Verfahren zur Herstellung eines verbundenen Substrates
Procédé pour fabriquer un substrat collé

(30) Priority: 21.02.1997 JP 5409897
(43) Date of publication of application: 26.08.1998
(73) Proprietor: Shin-Etsu Handotai Company Limited, Chiyoda-ku Tokyo (JP)
(72) Inventor: Takei, Tokio, Nagano-shi, Nagano-ken (JP); Nakamura, Susumu, Nagano-shi, Nagano-ken (JP); Nakazawa, Kazushi, Nagano-shi, Nagano-ken (JP)
(74) Representative: Cooper, John

(56) References cited:
- EP-A- 0 444 942
- PATENT ABSTRACTS OF JAPAN vol. 009, no. 031 (E-295), 9 February 1985 (1985-02-09) -& JP 59 175729 A (TOSHIBA KK), 4 October 1984 (1984-10-04)
- PATENT ABSTRACTS OF JAPAN vol. 1995, no. 05, 30 June 1995 (1995-06-30) -& JP 07 045485 A (SUMITOMO SITIX CORP), 14 February 1995 (1995-02-14)
- PATENT ABSTRACTS OF JAPAN vol. 013, no. 548 (E-856), 7 December 1989 (1989-12-07) -& JP 01 227441 A (SONY CORP), 11 September 1989 (1989-09-11)

## Description

### BACKGROUND OF THE INVENTION

### Field of the Invention:

The present invention relates to a method of manufacturing a bonding substrate composed of two substrates bonded together, and more particularly to a method of manufacturing a so-called bonding SOI (Silicon on Insulator) substrate in which two silicon monocrystalline substrates are bonded together via a silicon oxide film.

### Description of the Related Art:

There have been known various methods of manufacturing a bonding SOI substrate in which two silicon monocrystalline substrates are bonded together via a silicon oxide film. In the method shown, for example, in Japanese Patent Publication (*kokoku*) 5-46086, an oxide film is formed on at least one of two substrates; the two substrates are brought into close contact with each other with no foreign substance being interposed between the joint surfaces thereof; and the substrates are then subjected to heat treatment at a temperature of about 200 to 1200 °C in order to increase joint strength.

Since a bonding substrate whose joint strength has been increased by means of heat treatment can undergo a subsequent grinding and polishing process, the thickness of one substrate on which devices are to be fabricated can be reduced to a desired thickness through grinding or polishing in order to obtain an SOI layer for formation of semiconductor elements.

However, it is known that a bonding substrate manufactured in the above-described manner has an unjoined portion in an area extending about 1 - 3 mm from the peripheral edge of the substrate. In order to remove such an unjoined portion, there have been developed various techniques such as those shown in Japanese Patent Application Laid-Open (*kokai*) Nos. 3-89519, 4-263425, 3-250616, and 64-89346.

Although these methods can remove such an unjoined portion, they have the following drawbacks. In the techniques disclosed in Japanese Patent Application Laid-Open Nos. 3-89519 and 4-263425 in which the periphery of one substrate on which devices are to be fabricated (bond wafer) is ground to reach the other substrate which serves as a support substrate (base wafer), the shape of the base wafer changes greatly from the original shape. In the technique disclosed in Japanese Patent Application Laid-Open No. 3-250616 in which a piece of masking tape is applied to a wafer to cover the entire wafer except the periphery, and then etching is performed in order to remove the unjoined portion at the periphery of the wafer, the process becomes complicated. In the technique disclosed in Japanese Patent Application Laid-Open No. 64-89346 in which the entire periphery of a bonded wafer is removed through etching, the production requires a prolonged period of time and high costs and the productivity is low.

In order to solve these problems, there has been proposed another method of manufacturing a bonding substrate, as disclosed in Japanese Patent Application Laid-Open (*kokai*) No. 7-45485. In this method, an oxide film is formed on the surface of at least one of two wafers (bond and base wafers); the two wafers are brought into close contact with each other via the oxide film; the wafers are heat-treated in an oxidizing atmosphere in order to firmly join the wafers together; an unjoined portion at the periphery of the bond wafer is completely removed; and the bond wafer is ground/polished to a desired thickness, wherein the complete removal of the unjoined portion at the periphery of the bond wafer is carried out in such a way that the periphery of the bond wafer is first removed through grinding to a thickness such that damage does not reach the base wafer and subsequently the unjoined portion at the periphery of the bond wafer is completely removed through etching.

The above-described method has advantages that the shape of the base wafer is not changed, that use of masking tape or the like is not required, and that the process does not become unreasonably complicated.

In the above-described method, when the unjoined portion at the periphery of the bond wafer is completely removed through etching, the oxide film on the surface of the bond wafer is used as an etching prevention film. Therefore, during the etching, an under-cut portion is formed under the peripheral edge of the oxide film, and the peripheral edge of the oxide film left undissolved after the etching has a sharp shape. The sharp peripheral edge causes the following problems. That is, when the wafer is loaded in a basket and is transported to a subsequent process such as grinding and polishing, the sharp peripheral edge of the oxide film scratches a wafer support of the basket, or when the wafer is handled through use of a robot, the sharp peripheral edge of the oxide film is caught by the basket, resulting in a robot error or handling miss.

Such accidents raise a serious problem in the production process, and due to the handling miss of the robot, the wafer will be dropped, and thus be damaged or scratched. Further, when chips produced from the basket adhere to the wafer or a neighboring member such as a grinder or polisher, especially when such chips enter the space between a wafer chuck and the back surface of the wafer during the grinding/polishing process, the wafer cannot be held flat, with the result that a portion in contact with the chip is excessively ground or polished, and thus a dimple is formed at such a portion. In such a case, use of the wafer as an SOI or any other bonding substrate becomes impossible.

Moreover, when the grinding operation for removing the periphery of the bond wafer to a predetermined thickness is performed in a single step as in the prior art, the subsequent etching for complete removal of the unjoined portion at the peripheral of the bond wafer must be performed to a slightly excessive extent in order to prevent the unjoined portion from being left undissolved, thereby completely removing the unjoined portion. However, in such a method, since the time when the unjoined portion has been completely removed through etching is unknown, the amount of the excess etching must be set relatively large, resulting in an increase in the waste processing time. Further, since the etching amount and the etching rate cannot be known accurately, control of the etching process, including control of etchant, is difficult.

### SUMMARY OF THE INVENTION

The present invention has been accomplished to solve the above-mentioned problems, and an object of the invention is to provide an improved method of manufacturing a bonding substrate, in which method when the unjoined portion at the periphery of a bond wafer is completely removed through etching after grinding of the periphery of the bond wafer, the etched bond wafer has a peripheral shape that does not scratch a wafer support of a basket, nor is it caught by the basket, thereby preventing mechanical troubles such as robot error and handling miss, as well as problems related to quality such as dimples and scratches.

Another object of the present invention is to provide an improved method of manufacturing a bonding substrate, in which the amount and rate of etching performed during an etching process for removal of the unjoined portion can be accurately grasped in order to prevent excessive over-etching to thereby eliminate waste processing time, as well as to enable easy and accurate control of the etching process.

To achieve the above object, the present invention provides a method of manufacturing a bonding substrate, the method comprising the steps of bringing a semiconductor substrate and an insulator substrate into close contact with each other; heat-treating the substrates in an oxidizing atmosphere in order to firmly join the substrates together; grinding the periphery of the semiconductor substrate to a predetermined thickness; completely removing an unjoined portion at the periphery of the semiconductor substrate through etching; and grinding and/or polishing the semiconductor substrate in order to reduce the thickness of the semiconductor substrate to a desired thickness; wherein the process of grinding the periphery of the semiconductor substrate to a predetermined thickness is performed in two stages, and grinding in one of the two grinding stages is performed so as to reduce the thickness of the semiconductor substrate in an area including the unjoined portion to an extent that does not impart damage to the insulator substrate, while grinding in the other stage is performed in an area located inside the area including the unjoined portion such that at least an oxide film on the surface of the semiconductor substrate is removed to a point sufficient to prevent the substrate from contacting a wafer support of a wafer basket that is used for accommodating or transporting the substrate after the etching process, and such that the resulting thickness in said area is greater than that in the area including the unjoined portion.

As described above, in the method of manufacturing a bonding substrate according to the present invention, the process of grinding the periphery of the device-fabricating substrate to a predetermined thickness is performed in two stages. Therefore, even when the area which includes the unjoined portion is completely removed in the subsequent etching process, a silicon layer remains in an area located inside the area which includes the unjoined portion, so that the etching amount and the etching rate can be known accurately.

When the periphery of the device-fabricating substrate is ground in two stages in the above-described manner, the etching amount and the etching rate can be grasped accurately. Further, since the sharp portion of the peripheral edge of the surface oxide film-which is left undissolved after etching-does not contact a wafer support of a basket, there can be prevented the problems that the sharp portion scratches the wafer support of the basket and thus produces chips, and that when the wafer is handled through use of a robot, the sharp portion us caught by the basket to result in a robot error or handling miss.

Preferably, the invention further comprises the step of forming an oxide film on at least one of two semiconductor substrates serving as device-fabricating and support substrates to form the insulator substrate; and wherein said step of bringing a semiconductor substrate and an insulator substrate into close contact with each other comprises bringing the device-fabricating and support substrates into close contact with each other via the oxide film.

In the present invention, when the periphery of the semiconductor substrate is ground to a predetermined thickness, a grinding stone is preferably moved relative to the substrate from the periphery towards the center thereof.

When the grinding of the periphery of the bond wafer to a predetermined thickness is performed by relative movement of a grinding stone from the periphery of the substrate towards the center thereof as described above, damage in the direction of thickness of the wafer decreases, so that the bond wafer can be ground to a small thickness without generation of damage in the base wafer.

In the present invention, since the process of grinding the periphery of the device-fabricating substrate to a predetermined thickness for removal of the unjoined portion is performed in two stages, the sharp portion of the peripheral edge of the surface oxide film-which is left undissolved after etching-does not contact a wafer support of a basket. Therefore, the substrate does not scratch the wafer support of the basket, nor is it caught by the basket, so that there can be prevented mechanical troubles such as robot error and handling miss, as well as problems related to quality such as dimples and scratches. Thus, bonding substrates of high quality can be manufactured.

Moreover, in the present invention, since the process of grinding the periphery of the device-fabricating substrate to a predetermined thickness is performed in two stages, and therefore the silicon layer in the inside area not including the unjoined portion is left after etching, the amount and rate of the etching for removing the unjoined portion can be known accurately. Therefore, excessive over-etching is prevented in order to eliminate waste processing time, and easy and accurate control of the etching process is enabled.

### BRIEF DESCRIPTION OF THE DRAWINGS

Figs. 1A-1H are diagrams illustrating a general process for manufacturing a bonding substrate according to the present invention; and
Figs. 2A and 2B are enlarged partial views each showing the cross-sectional shape of the periphery of a wafer subjected to a two-stage grinding according to the present invention, wherein Fig. 2A shows the cross-sectional shape after grinding and FIG. 2B shows the cross-sectional shape after etching;
FIGS. 3A and 3B are enlarged partial views each showing the cross-sectional shape of the periphery of a wafer subjected to a conventional grinding, wherein FIG. 3A shows the cross-sectional shape after grinding and FIG. 3B shows the cross-sectional shape after etching;
FIG. 4 is an explanatory view showing the case where the periphery of a bond wafer is ground by relative movement of a grinding stone from the periphery of the bond wafer toward the center thereof; and
FIG. 5 shows a state in which wafers are accommodated in a wafer basket, wherein section (A) shows an ordinary mirror-polished silicon wafer, section (B) shows a bonding substrate after being subjected to joining and heat treatment, section (C) shows a bonding substrate which was etched after the periphery had been ground by a single-stage grinding, and section (D) shows a bonding substrate which was etched after the periphery had been ground by a two-stage grinding of the present invention.

### DESCRIPTION OF THE PREFERRED EMBODIMENT

With reference to the drawing, an embodiment of the present invention will next be described for a case where two semiconductor substrates are bonded together. However, the present invention is not limited thereto.

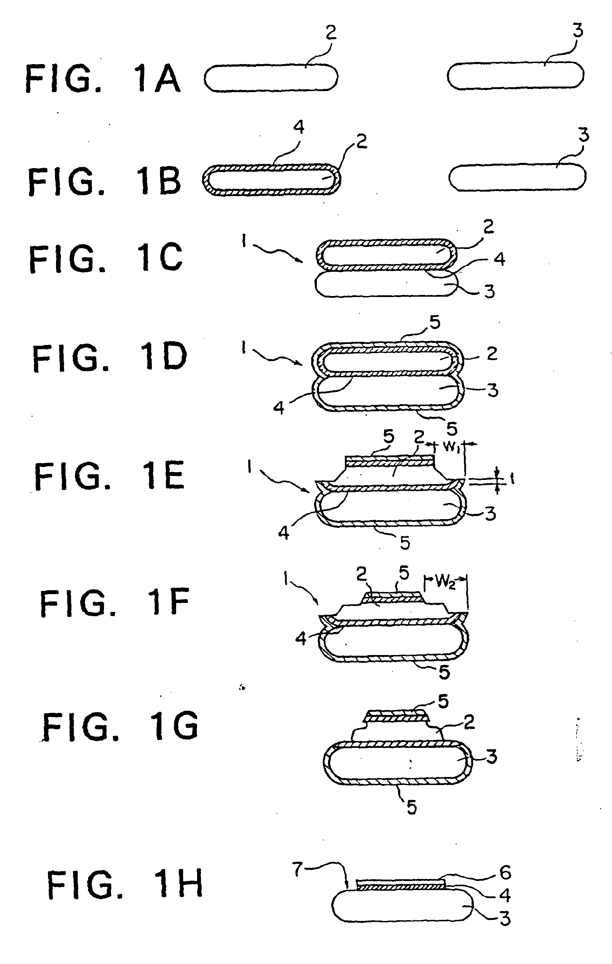

The method according to the present invention will now be described step by step with reference to FIGS. 1A - 1H First, material wafers (monocrystalline silicon mirror-polished wafers, for example, having a diameter of 125mm (5 inches) and a <100> orientation, which are manufactured in accordance with the Czochralski method) are prepared as a bond wafer 2 and a base wafer 3 (FIG. 1A). Among the prepared silicon monocrystalline wafers, the bond wafer 2 is heat-treated to form an oxide film 4 on the surface thereof (FIG. 1B).

Subsequently, the bond wafer 2 carrying the oxide film 4 is brought into close contact with the base wafer 3 in a clean atmosphere (FIG. 1C). The bond wafer 2 and the base wafer 3 are then heat-treated in an oxidizing atmosphere in order to firmly join the bond wafer 2 and the base wafer 3 so as to yield a bonding substrate 1. The heat treatment is performed at a temperature of 200 - 1200 °C in an atmosphere that contains oxygen or water vapor (FIG. 1D). At this time, the bond wafer 2 and the base wafer 3 are firmly joined together, and an oxide film 5 is formed on the entire outer surface of the bonding substrate 1. The oxide film 5 serves as an etching prevention film in a subsequent step.

In an area extending about 2 mm from the peripheral edge of the thus-joined bonding substrate 1, the bond wafer 2 and the base wafer 3 have an unjoined portion. The unjoined portion must be removed because such an unjoined portion cannot be used as an SOI layer for fabrication of semiconductor devices, and may peel off in a subsequent process and may cause various problems.

In order to remove the unjoined portion, as shown in FIG. 1E, the periphery of the bond wafer 2 where the unjoined portion exists is ground such that the thickness of the unjoined portion decreases to a predetermined thickness t. The grinding operation can remove the unjoined portion with high speed and high accuracy.

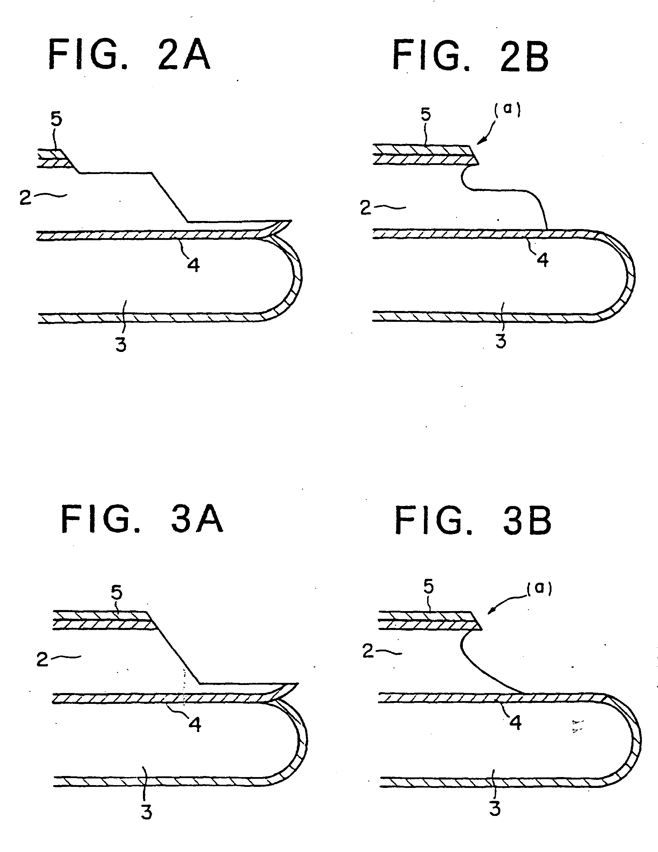

Conventionally, the grinding operation is performed in a single stage, and the unjoined portion is then removed completely by etching the periphery of the bond wafer 2. However, in such a method, as shown in FIGS. 3A and 3B, after the unjoined portion at the periphery of the bond wafer is removed through etching, the peripheral edge (a) of the surface oxide film 5 used as an etching prevention film has a sharp shape, so that various problems occur due to the sharp peripheral edge. That is, when the wafer is loaded in a basket and is transported to a subsequent process such as grinding and polishing, the sharp peripheral edge (a) of the oxide film scratches a wafer support of the basket, and chips produced from the basket adhere to the wafer or a neighboring member such as a grinder or polisher, so that the wafer has a dimple after grinding/polishing. Further, when the wafer is handled through use of a robot, the sharp peripheral edge (a) of the oxide film is caught by the basket, resulting in a robot error or handling miss.

Moreover, when the grinding operation for removing the periphery of the bond wafer to a predetermined thickness is performed in a single step, the subsequent etching for complete removal of the unjoined portion at the peripheral of the bond wafer must be performed to a slightly excessive extent in order to prevent the unjoined portion from being left undissolved, thereby completely removing the unjoined portion. However, in such a method, since the time when the unjoined portion has been completely removed through etching is unknown, the amount of the excess etching must be set relatively large, resulting in an increase in the waste processing time. Further, since the etching amount and the etching rate cannot be known accurately, control of the etching process, including control of etchant, is difficult.

In order to solve the above-described problems, in the present invention, the grinding for removing the periphery of the bond wafer to a predetermined thickness is performed in two stages, as shown in FIGS. 1E and 1F, in order to prevent the peripheral edge (a) of the oxide film of the bond wafer from contacting a wafer support of a basket. Further, in the second stage, the bond wafer is ground to a thickness greater than that in the area including the unjoined portion, so that the silicon layer in that area is left undissolved after etching. Therefore, the etching amount and the etching rate can be accurately measured from the thickness of the silicon layer (see FIGS. 2A and 2B).

In such a two-stage grinding, either one of two grinding stages may be performed first, and the sequence of the two grinding stages may be determined depending on the specifications of a grinder and other factors. However, one grinding stage is performed so as to reduce the thickness of the bond wafer 2 (the device-fabricating substrate) in an area including the unjoined portion to an extent that does not impart damage to the buried oxide layer 4 or the base wafer 3, while the other grinding stage is performed in an area located to the inside of the area including the unjoined portion (hereinafter may be referred to as "inside area") such that at least the oxide film on the surface of the bond wafer 2 is removed to a position sufficient to prevent the wafer from contacting a wafer support of a wafer basket that is used for accommodating or transporting the wafer after the etching process for completely removing the unjoined portion of the wafer and such that the thickness becomes greater than that in the area including the unjoined portion.

Among the two grinding stages, one grinding stage is performed so as to reduce the thickness of the bond wafer 2 in an area W₁ including the unjoined portion at the periphery of the bond wafer 2 to an extent that does not impart damage to the buried oxide layer 4 or the base wafer 3. This grinding is the same as the conventional grinding, and is necessary for removal of the unjoined portion. Further, through this grinding, the predetermined thickness t is made small to an extent possible in order to reduce the amount of stock removal in a subsequent etching process, thereby shortening the process time.

It is well known that when a silicon wafer is mechanically ground, mechanical damage is generated in the wafer, unlike the case of etching. Therefore, if the predetermined thickness t is reduced excessively, damage such as mechanical damage reaches the buried oxide layer 4 or the base wafer 3. In this case, when the unjoined portion at the periphery of the bond wafer 2 is completely removed by subsequent etching, etchant may reach the surface of the base wafer 3 via the damaged buried oxide layer 4 and form a scratch or andulation in that portion (terrace portion 7), thereby decreasing yield in the subsequent device-fabricating process.

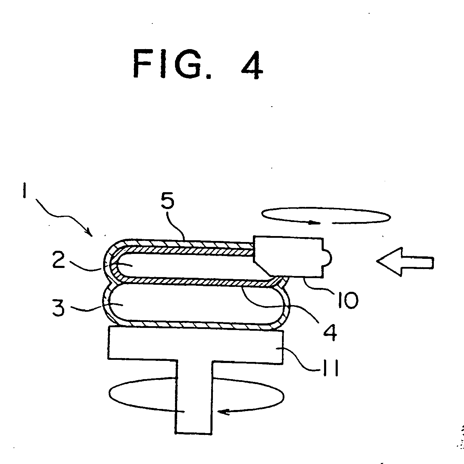

Therefore, it is important to determine a way of grinding the periphery of the bond wafer 2 to as small a thickness as possible without imparting damage to the buried oxide layer 4 or the base wafer 3. Therefore, as shown in FIG. 4, in order to grind the periphery of the bond wafer 2 to a predetermined thickness t, the grinding wheel 10 is moved radially in relation to the bond wafer 2 such that the grinding wheel 10 moves from the periphery toward the center of the bond wafer 2.

When the periphery of the bond wafer 2 is ground from the periphery toward the center of the bond wafer 2, damage is generated in a direction toward the center of the wafer, which is the advancing direction of the grinding wheel, and damage is hardly generated in the thicknesswise direction.

Therefore, even when the peripheral portion of the bond wafer 2 is ground to a thickness as small as 20 - 150 µm , damage does not reach the buried oxide layer 4 or the base wafer 3.

Meanwhile, the other grinding stage is performed in an area located to the inside of the area W₁ including the unjoined portion such that at least the oxide film on the surface of the bond wafer 2 is removed to a point sufficient to prevent the wafer from contacting a wafer support of a wafer basket that is used for accommodating or transporting the wafer after the etching process for completely removing the unjoined portion of the wafer and such that the thickness becomes greater than that in the area including the unjoined portion.

When the oxide film on the surface of the bond wafer is removed in the area located to the inside of the area W₁ including the unjoined portion to a point sufficient to prevent the wafer from contacting a wafer support of a wafer basket, chips will not be generated from scratching of the wafer support of the wafer basket and the wafer will not be caught by the wafer basket, because even if the peripheral edge of the oxide film on the surface of the bond wafer has a sharpness during a subsequent etching process, the sharp edge does not contact the wafer support of the wafer basket.

Further, in this grinding stage, grinding is performed such that thickness of the bond wafer in the inside area becomes greater than that in the area in which the unjoined portion exists. Since the unjoined portion does not exist in the inside area, and the inside area is used as an SOI layer, it is natural to prevent the bond wafer from being completely removed in the etching process. Therefore, in the inside area, the thickness of the bond wafer must be made greater than the thickness of a finally obtained SOI layer (e.g., about a few micrometers).

In this case, the grinding amount may be set freely insofar as the thickness in the inside area becomes at least 10 µm greater than that in the area in which the unjoined portion exists. However, the grinding must be performed such that at least the surface oxide film 5 of the bond wafer is removed. If the grinding is not performed in such a manner, that portion is not etched, thereby causing the same problem as that in the prior art.

Since the inside area is ground such that the thickness of the bond wafer becomes greater than that in the area in which the unjoined portion exists, the silicon layer at this portion is left undissolved after etching, as shown in FIG. 2B. In this case, the etching amount and the etching rate can be known accurately from the thickness, so that control of the etching process can be performed through control of the temperature and concentration of etchant and the like.

FIG. 2A shows an example of the cross-sectional view of the wafer in which the periphery of the bond wafer has been subjected to two-stage grinding as shown in FIG. 1F.

In this case, the width W₂ of the periphery of the bond wafer 2 to be subjected to the two-stage grinding is determined in accordance with the height of a wafer support of a wafer basket to be used such that the sharp edge (a) of the surface oxide film of the bond wafer after etching becomes higher than the wafer support. For example, when the height of the wafer support is 10 mm, the surface oxide film of the bond wafer is removed in an area extending over 11 mm from the peripheral edge of the wafer.

After completion of the two-stage grinding of the peripheral portion, as shown in FIGS. 1G and 2B, the unjoined portion at the periphery of the bond wafer 2 is completely removed through etching. This etching can be performed through immersion of the bonding substrate 1 in an etchant whose etching rate for silicon monocrystal is greatly higher than that for oxide film. That is, although the periphery of the bond wafer 2 is etched by the etchant because the silicon has been exposed through grinding, the remaining portions of the bonding substrate 1 are not etched because these portions are covered by the oxide film 5. An example of such etching includes so-called alkali etching that utilizes KOH, NaOH, or the like.

In the present invention, since the thickness of the bond wafer 2 is made sufficiently small in the area in which the unjoined portion at the periphery of the bond wafer 2 exists, the unjoined portion existing at the periphery of the bonding substrate 1 can be completely removed by etching for a short period of time. Further, since the portion in the inside area from which the surface oxide film has been removed is made thicker than that in the area including the unjoined portion, the silicon layer remains even when the unjoined portion is completely removed through etching.

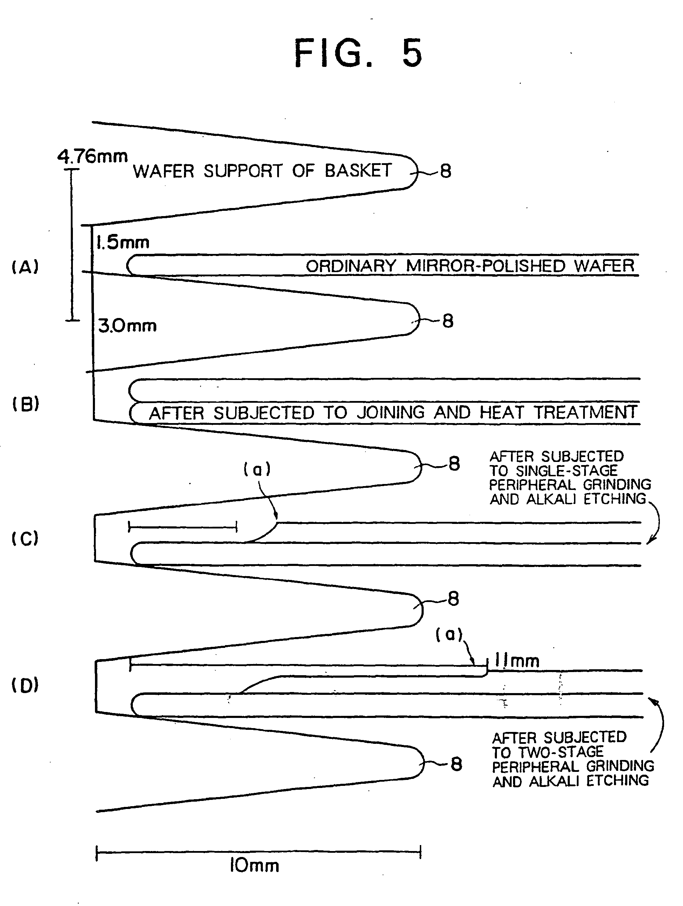

FIG. 5 shows a state in which the bonding substrate 1 whose unjoined portion has been removed through etching is accommodated within a wafer basket (i.e., basket for 125mm (5-inch) wafers, Model A182-50MU, product of Fluoroware Corp.). For comparison purpose, section (A) of FIG. 5 shows an ordinary mirror-polished silicon wafer; section (B) of FIG. 5 shows a bonding substrate after being subjected to joining and heat treatment; section (C) of FIG. 5 shows a bonding substrate which was etched after the periphery had been ground by conventional single-stage grinding; and section (D) of FIG. 5 shows a bonding substrate which was etched after the periphery had been ground by the two-stage grinding of the present invention.

As is apparent from FIG. 5, when a bonding substrate which was etched after the periphery including the unjoined portion had been ground by conventional single-stage grinding is accommodated in the wafer basket, the height of the sharp peripheral edge (a) is less than that of the wafer support 8 (because the distance between the peripheral edge of the base wafer to the sharp edge (a) is less than the height of the wafer support), the wafer support 8 may be scratched by the sharp edge (a) or the sharp edge (a) may stick in the wafer support and be caught thereby while the wafer is transported, for example (section (C) of FIG. 5).

By contrast, when a bonding substrate which was etched after the periphery including the unjoined portion had been ground by the two-stage grinding of the present invention is accommodated in the wafer basket, the height of the sharp peripheral edge (a) is greater than that of the wafer support 8 (because the distance between the peripheral edge of the base wafer to the sharp edge (a) is greater than the height of the wafer support), there can be prevented the above problems that the wafer support 8 is scratched by the sharp edge (a) or the sharp edge a sticks in the wafer support or is caught thereby while the wafer is transported, (section (D) of FIG. 5).

The thus-obtained bonding substrate 1 is finally subjected to the process shown in FIG. 1H, in which the surface of the bond wafer 2 is ground and/or polished in order to reduce the thickness of the bond wafer 2 to a desired thickness in accordance with an ordinary manner. Thus, a bonding substrate having an SOI layer 6 can be manufactured.

### EXAMPLES

Next, descriptions will be given of an example of the present invention and a comparative example.

### (Example and Comparative Example)

400 mirror-polished CZ substrates having a diameter of 125 mm (5 inches) and a thickness of 625 µm (conductive type: p type; resistivity: 4 - 6 Ω·cm) were prepared and divided into 200 bond wafers and 200 base wafers. These wafers were joined in accordance with the processes shown in FIGS. 1A - 1D in order to yield 200 bonding substrates as shown in FIG. 1D.

For 100 of the 200 bonding substrates, the periphery of the bond wafer was subjected to the two-stage grinding of the present invention (Example). In the first grinding stage, the peripheral portion of the bond wafer radially extending over about 3 mm was ground such that the thickness of the bond wafer in that area became 100 µm. In the second grinding, the bond wafer was ground to a depth of 50 µm to partially remove the bond wafer in an area extending over 11 mm from the peripheral edge thereof (the thickness of the oxide film on the surface of the bond wafer was about 2 µm).

The remaining 100 bonding substrates were ground in the same manner except that the second-stage grinding was not performed (Comparative Example).

The grinding was performed through use of a #800 diamond grinding wheel, which was rotated at a peripheral speed of 1600 m/min in the direction opposite to the rotational direction of the wafer, which was rotated at a peripheral speed of 300 mm/min. The grinding was performed at the advancing speed of 0.6 mm/min. The peripheral portion of each substrate was radially ground from the periphery toward the center of the wafer, thereby preventing the base wafer and the buried oxide layer from being damaged.

The 200 bonding substrates whose bond wafers had ground peripheral portions were immersed into a solution of 50% NaOH at 70 °C for about 3.5 hours, which is a condition for etching a silicon monocrystalline of a thickness of about 130 µm, in order to completely remove the unjoined portion at the periphery of the wafer.

Subsequently, the bonding substrates were loaded in the above-described wafer basket for 125mm (5-inch) wafers manufactured by Fluoroware Corp. in an ordinary manner, and were subjected to ordinary grinding/polishing in order to complete the manufacture of a bonding substrate having an SOI layer of 2 µm thickness as shown in FIG. 1H. At this time, the loading and unloading of the bonding substrates into and from the basket were performed through use of a wafer handling robot that applies suction to the back surface of the substrate.

In the above-described manner 200 SOI substrates were manufactured, and a check was made as to whether any mechanical trouble such as handling miss of the robot occurred in the successive processes. Also, the defect rate of the SOI substrates stemming from dimples formed on the SOI substrates was examined.

As a result, it was found that when the SOI substrates were manufactured in accordance with the conventional single-stage grinding (Comparative Example), a robot error occurred two times when the substrates were unloaded from the wafer basket after the wafer basket was transported to the grinding process. Also, dimple defect was found in two bonding substrates. By contrast, when the SOI substrates were manufactured in accordance with the two-stage grinding of the present invention (Example), neither robot trouble nor dimple defect occurred.

In the above-described embodiment, the description is focused on the case where two semiconductor substrates are joined together in order to manufacture a bonding substrate. However, the present invention is also effective in removing peripheral unjoined portions that are produced in a manufacturing process in which a bonding substrate is manufactured through joining of a semiconductor wafer and an insulator substrate made of quartz, silicon carbide, silicon nitride, alumina, sapphire, or other ceramic materials.

## Claims

1. A method of manufacturing a bonding substrate which comprises the steps of bringing a semiconductor substrate and an insulator substrate into close contact with each other; heat-treating the substrates in an oxidizing atmosphere in order to firmly join the substrates together; grinding the periphery of the semiconductor substrate to a predetermined thickness; completely removing an unjoined portion at the periphery of the semiconductor substrate through etching; and grinding and/or polishing the semiconductor substrate in order to reduce the thickness of the semiconductor substrate to a desired thickness, **characterized in that** the process of grinding the periphery of the semiconductor substrate to a predetermined thickness is performed in two stages, and grinding in one of the two grinding stages is performed so as to reduce the thickness of the semiconductor substrate in an area including the unjoined portion to an extent that does not impart damage to the insulator substrate, while grinding in the other stage is performed in an area located inside the area including the unjoined portion such that at least an oxide film on the surface of the semiconductor substrate is removed to a point sufficient to prevent the substrate from contacting a wafer support of a wafer basket that is used for accommodating or transporting the substrate after the etching process, and such that the resulting thickness in said area is greater than that in the area including the unjoined portion.

2. The method of manufacturing a bonding substrate according to claim 1, comprising the step of forming an oxide film on at least one of two semiconductor substrates serving as device-fabricating and support substrates to form the insulator substrate; and wherein said step of bringing a semiconductor substrate and an insulator substrate into close contact with each other comprises bringing the device-fabricating and support substrates into close contact with each other via the oxide film.

3. A method of manufacturing a bonding substrate according to Claim 1 or claim 2, **characterized in that** when the periphery of the semiconductor substrate is ground to a predetermined thickness, a grinding stone is moved relative to the substrate from the periphery toward the center of the substrate.

## Patentansprüche

1. Ein Verfahren zum Herstellen eines Bondsubstrats, das die folgenden Schritte beinhaltet: Miteinander-in-engen-Kontakt-Bringen eines Halbleitersubstrats und eines Isolatorsubstrats; Wärmebehandeln der Substrate in einer oxidierenden Atmosphäre, um die Substrate fest zusammenzubinden; Schleifen der Peripherie des Halbleitersubstrats auf eine zuvor bestimmte Dicke; vollständiges Entfernen eines nicht verbundenen Abschnitts an der Peripherie des Halbleitersubstrats durch Ätzen; und Schleifen und/oder Polieren des Halbleitersubstrats, um die Dicke des Halbleitersubstrats auf eine gewünschte Dicke zu reduzieren, **dadurch gekennzeichnet, dass** der Vorgang des Schleifens der Peripherie des Halbleitersubstrats auf eine zuvor bestimmte Dicke in zwei Stufen ausgeführt wird, und dass das Schleifen in einer der zwei Schleifstufen ausgeführt wird, um die Dicke des Halbleitersubstrats in einem Bereich, der den nicht verbundenen Abschnitt einschließt, um ein Maß, das dem Isolatorsubstrat keinen Schaden zufügt, zu reduzieren, während das Schleifen in der anderen Stufe in einem Bereich ausgeführt wird, der sich innerhalb des Bereichs, der den nicht verbundenen Abschnitt einschließt, befindet, so dass zumindest ein Oxidfilm auf der Oberfläche des Halbleitersubstrats bis zu einem Punkt entfernt wird, der ausreicht, um zu verhindern, dass das Substrat mit einer Waferstütze eines Waferkorbs, der zum Unterbringen oder Transportieren des Substrats nach dem Ätzvorgang verwendet wird, in Kontakt kommt, und so dass die resultierende Dicke in dem Bereich größer ist als die in dem Bereich, der den nicht verbundenen Abschnitt einschließt.

2. Verfahren zum Herstellen eines Bondsubstrats gemäß Anspruch 1, das den Schritt des Bildens eines Oxidfilms auf zumindest einem von zwei Halbleitersubstraten, die als ein Substrat zur Fertigung eines Bauelements und als ein Stützsubstrat dienen, um das Isolatorsubstrat zu bilden, beinhaltet; und wobei der Schritt des Miteinander-in-engen-Kontakt-Bringens eines Halbleitersubstrats und eines Isolatorsubstrats das Miteinander-in-engen-Kontakt-Bringen des Substrats zur Fertigung des Bauelements und des Stützsubstrats mittels des Oxidfilms beinhaltet.

3. Verfahren zum Herstellen eines Bondsubstrats gemäß Anspruch 1 oder Anspruch 2, **dadurch gekennzeichnet, dass**, wenn die Peripherie des Halbleitersubstrats auf eine zuvor bestimmte Dicke geschliffen wird, ein Schleifstein relativ zu dem Substrat von der Peripherie zu der Mitte des Substrats bewegt wird.

## Revendications

1. Une méthode pour manufacturer un substrat de liaison, laquelle comprend les étapes d'amener un substrat semi-conducteur et un substrat isolant en contact étroit l'un avec l'autre ; traiter thermiquement les substrats dans une atmosphère oxydante afin de joindre fermement les substrats ensemble ; meuler la périphérie du substrat semi-conducteur jusqu'à une épaisseur prédéterminée ; ôter complètement une portion non jointe au niveau de la périphérie du substrat semi-conducteur par décapage ; et meuler et / ou polir le substrat semi-conducteur afin de réduire l'épaisseur du substrat semi-conducteur jusqu'à une épaisseur souhaitée, **caractérisée en ce que** le procédé consistant à meuler la périphérie du substrat semi-conducteur jusqu'à une épaisseur prédéterminée est effectué en deux phases, et le meulage dans l'une des deux phases de meulage est effectué de façon à réduire l'épaisseur du substrat semi-conducteur dans une zone incluant la portion non jointe jusqu'à une étendue qui ne confère pas d'endommagement au substrat isolant, alors que le meulage dans l'autre phase est effectué dans une zone située à l'intérieur de la zone incluant la portion non jointe de telle sorte qu'au moins un film d'oxyde sur la surface du substrat semi-conducteur soit ôté jusqu'à un point suffisant pour empêcher le substrat d'entrer en contact avec un support de plaquette d'un panier à plaquette qui est utilisé pour loger ou transporter le substrat après le procédé de décapage, et de telle sorte que l'épaisseur résultante dans ladite zone soit supérieure à celle dans la zone incluant la portion non jointe.

2. La méthode pour manufacturer un substrat de liaison selon la revendication 1, comprenant l'étape de former un film d'oxyde sur au moins un substrat parmi deux substrats semiconducteurs servant de substrat de fabrication de dispositifs et de substrat de support pour former le substrat isolant ; et dans laquelle ladite étape d'amener un substrat semi-conducteur et un substrat isolant en contact étroit l'un avec l'autre comprend amener le substrat de fabrication de dispositifs et le substrat de support en contact étroit l'un avec l'autre par le biais du film d'oxyde.

3. Une méthode pour manufacturer un substrat de liaison selon la revendication 1 ou la revendication 2, **caractérisée en ce que** lorsque la périphérie du substrat semi-conducteur est meulée jusqu'à une épaisseur prédéterminée, une pierre de meulage est déplacée relativement au substrat de la périphérie en direction du centre du substrat.
